# EUROPÄISCHE PATENTSCHRIFT

(11) **EP 2 219 276 B1**
(45) Veröffentlichungstag und Bekanntmachung des Hinweises auf die Patenterteilung: **02.12.2015**
(21) Anmeldenummer: 09001865.6
(22) Anmeldetag: 11.02.2009
(51) Int. Cl.: H01L 31/02, H02J 3/38

(54) **Photovoltaikanlage zur dreiphasigen Einspeisung in ein elektrisches Energieversorgungsnetz**
Photovoltaic assembly for three-phase feeding into an electric energy supply network
Installation photovoltaïque destinée à l'alimentation triphasée dans un réseau d'alimentation en énergie électrique

(43) Veröffentlichungstag der Anmeldung: 18.08.2010
(73) Patentinhaber: SMA Solar Technology AG, 34266 Niestetal (DE)
(72) Erfinder: Bremicker, Sven, 36211 Alheim-Baumbach (DE); Greizer, Frank, 34260 Kaufungen (DE); Laschinski, Joachim, 34131 Kassel (DE); Victor, Matthias Dr., 34266 Niestetal (DE); Simon, Peter, 37235 Hess. Lichtenau (DE)
(74) Vertreter: Lahnor, Peter

(56) Entgegenhaltungen:
- EP-A- 1 841 050
- "Eigenerzeugungsanlagen am Niederspannungsnetz" [Online] September 2005 (2005-09), VWEV ENERGIEVERLAG , FRANKFURT AM MAIN , XP002540292 ISBN: 3-8022-0838-2 Gefunden im Internet: URL:http://www.eswe-versorgung.de/uploads/ media/TV-N_Eigen-NS.pdf> [gefunden am 2009-07-28] * Seite 19 - Seite 34 * * Seite 50 - Seite 51 * * Abbildungen 6-1 *
- "Gesetz zur Neuregelung des Rechts der Erneuerbaren Energien im Strombereich und zur Änderung damit zusammenhängender Vorschriften" BUNDESGESETZBLATT JAHRGANG 2008, Bd. I, Nr. 49, 31. Oktober 2008 (2008-10-31), Seiten 2074-2100, XP002540291 Bonn Gefunden im Internet: URL:http://www.bgblportal.de/BGBL/bgbl1f/b gbl108s2074.pdf> [gefunden am 2009-07-27]

## Beschreibung

Die Erfindung betrifft eine Photovoltaikanlage nach dem Oberbegriff des Anspruches 1.

Wenn Photovoltaikanlagen mit einem Energieversorgungsnetz verbunden werden sollen, müssen eine Reihe von Anforderungen beachtet werden, die seitens eines Energieversorgungsunternehmens vorgegeben sind. Bei einer dreiphasigen Einspeisung dieser Art darf ein Leistungsunterschied zwischen den Phasen nicht größer als 4,6 kVA sein. Ein 10-Minuten-Mittelwert muss einen Wert kleiner als 5kW aufweisen.

Eine weitere Anforderung seitens eines Energieversorgungsunternehmens ist, dass eine externe Spannungsüberwachung zu einer Netzüberwachungseinrichtung (ENS) erfolgt. Dadurch kann z. B. eine 110% (z. B. 253 Volt) Abschaltgrenze eingehalten werden.

Auch ist wichtig bei einem Überangebot an Energie im Energieversorgungsnetz, dass bevorzugt dezentrale Einspeiser per Fernabschaltung abgeschaltet werden können, da im Netz nur soviel Energie bereitgestellt werden darf, wie auch tatsächlich verbraucht wird.

Zudem ist eine Inselnetzerkennung notwendig, damit bei Wartungsarbeiten im Netz keine Gefährdung des Wartungspersonals durch noch vorhandene Spannung ausgeht.

All diese Anforderungen verteuern eine Photovoltaikanlage, wenn diese Energie in ein öffentliches Energieversorgungsnetz einspeisen soll.

Eine Photovoltaikanlage, mit der die Schieflastanforderungen auch bei einphasigen Wechselrichtern mit mehr als 4,6 kVA gelöst werden, wird in der EP 1 841 050 A2 vorgestellt. Diese Lösung ist auch als "Power Balancer" bekannt. Die Anlage umfasst mehrere einphasige Wechselrichter. Jeder Wechselrichter ist mit einer Ausfall-Messschaltung bzw. einer Mitnahmeschaltung versehen, die mit einer externen Kommunikationsverbindung verbunden ist. Diese Schaltung hat die Aufgabe, einen Ausfall eines Wechselrichters zu detektieren, so dass bei einer asymmetrischen Leistungseinspeisung die Leistung der übrigen Wechselrichter reduziert wird. Jeder der Wechselrichter ist mit einer selbsttätigen Freischaltstelle versehen. Eine Strommessung erfolgt nur intern im Wechselrichter zur Ausfallerkennung. Zwischen den Wechselrichtern und dem Netz befindet sich ein Netzschütz. Diese Anlage hat einerseits den Nachteil, dass keine Messung am Netzanschlusspunkt erfolgt und andererseits, dass ein zusätzliches zentrales Schaltorgan bzw. ein Netzschütz eingesetzt werden muss.

Eine andere Ausbildung einer Photovoltaikanlage zur Einspeisung in ein elektrisches Netz ist aus der DE 10 2004 025 923 A1 bekannt. Diese umfasst mehrere Wechselrichter. Ein Kommunikationsbus verbindet die Wechselrichter datentechnisch untereinander, wobei ein zentrales Steuer- und Überwachungsgerät vorgesehen ist, welches gleichfalls mit dem Kommunikationsbus verbunden ist. Weiterhin ist eine Netzüberwachungseinrichtung vorhanden, die die Wechselrichter bei Nichteinhaltung vorgebbarer Netzüberwachungskriterien zumindest zeitweise abschaltet. Durch das zentrale Steuer- und Überwachungsgerät wird eine gegenseitige Beeinflussung und unnötige Abschaltung der Wechselrichter vermieden. Nachteilig bei dieser Lösung ist, dass eine Überwachung ausschließlich in der zentralen Mess- und Steuerstelle erfolgt, so dass eine Ausführung als Power Balancer nicht möglich ist. Eine Netzüberwachung erfolgt nur in Bezug auf eine Spannung bzw. eine Frequenz. Zudem ist nur eine passive Inselnetzüberwachung, d. h. eine dreiphasige Spannungsüberwachung, möglich. Diese ist jedoch nicht zulässig bei Wechselrichtern, die ihre Phasenströme individuell regeln. Für den Einsatz mit einigen Ausführungsformen von dreiphasigen Wechselrichtern ist diese Lösung daher nicht geeignet.

Der Erfindung liegt die Aufgabe zugrunde, eine Photovoltaikanlage der eingangs genannten Art zu schaffen, die den Forderungen seitens eines Energieversorgungsunternehmens Rechnung trägt und zudem kostengünstig zu verwirklichen ist.

Diese Aufgabe wird gelöst durch eine Photovoltaikanlage mit dem Merkmalen von Anspruch 1. Es ist eine zwischen den Wechselrichtern und dem Energieversorgungsnetz angeschlossene zentrale Steuer- und Überwachungseinheit vorgesehen, wobei die Steuer- und Überwachungseinheit eine Netzüberwachungseinrichtung am Einspeisepunkt des Netzes aufweist, die ein oder mehrere Netzparameter misst, sowie mindestens eine Kommunikationsverbindung zwischen den einzelnen Photovoltaikwechselrichtern oder den einzelnen Trenneinrichtungen und der angeschlossenen zentralen Steuer- und Überwachungseinheit, so dass die einzelnen Wechselrichter durch ein Steuerbefehlsignal der Steuer- und Überwachungseinheit durch ihre Trenneinrichtungen vom Energieversorgungsnetz, zumindest zeitweise, trennbar sind.

Durch die Erfindung ist in einfacher Weise die Einsparung eines zentralen Netzkuppelschalters trotz Beibehaltung einer zentralen Abschaltmöglichkeit entweder durch eine manuelle Signalgebung oder durch ein Messsignal möglich. Auch kann neben einer Spannungs- und Frequenzmessung eine Inselnetzerkennung realisiert werden, und zwar ganz gleich bei welchem Wechselrichtertyp, ob ein- oder dreiphasig und sogar topologieunabhängig.

Die Erfindung beruht auf dem Gedanken, einen intelligenten Netzkuppelschalter bzw. eine Netzschnittstelle mit Kommunikation zwischen dem oder den Wechselrichtern und dem Energieversorgungsunternehmen einzusetzen, und zwar mit zumindest einer Netzspannungserfassung am Einspeisepunkt zur Schieflastbeobachtung.

Durch die erfindungsgemäße Ausführung ist bei vorhandener Kommunikationsstruktur somit nur ein geringer Mehraufwand mit nur geringen Mehrkosten notwendig.

Auch erlaubt die Erfindung durch die zentrale Messung und Überwachung eine 100%-ige Vermeidung von Schieflast auch durch Abschaltung. An einer Vermeidung von Schieflasten haben Energieversorgungsunternehmen ein hohes Interesse.

Durch die Struktur der erfindungsgemäßen Anlage ist eine beliebige Anzahl von Wechselrichtern möglich, was jederzeit eine modulare Erweiterung der Anlage erlaubt.

Um die Qualität der Einspeisung zu verbessern, ist es vorteilhaft, wenn die zentrale Steuer- und Überwachungseinheit eine Schieflast-Erkennungsfunktion und/oder eine Schieflastregelungsfunktion umfasst. Die von Energieversorgungsunternehmen geforderten Grenzen können ohne Weiteres dadurch eingehalten werden, dass entweder Leistungen einzelner Phasen gemäß der DE 10 2006 003 904 A1 begrenzt oder durch die Freischaltstelle ganz abgeschaltet werden. Eine Anordnung der Abschaltorgane ist in jedem Wechselrichter vorhanden. Diese erfindungsgemäße Überwachung erfolgt jedoch zentral. Weiterhin ist durch die Kommunikationsverbindung eine Kommunikation zwischen den Wechselrichtern zur Abschaltung bzw. Leistungsreduktion möglich, wenn das Abschalt- bzw. Schieflastkriterium bei einem Wechselrichter erfüllt ist.

Diese Forderungen können eingehalten werden, wenn eine Regelung nach der Erfindung so erfolgt, dass ein Leistungsunterschied zwischen den einzelnen Phasen nicht mehr als 4,6 kVA und/oder ein 10 Minuten-Mittelwert weniger als 5 kW beträgt.

Weitere vorteilhafte Ausgestaltungen der Erfindung sind in den Unteransprüchen beschrieben.

In einer vorteilhaften Weiterbildung der erfindungsgemäßen Anlage ist vorgesehen, dass die Steuer- und Überwachungseinheit derart ausgeführt ist, dass bei Über- oder Unterschreitung mindestens eines vorgegebenen Grenzwertes die Photovoltaikwechselrichter durch ein Steuerbefehlsignal der Kommunikationsverbindung durch ihre Trenneinrichtungen vom Energieversorgungsnetz trennbar sind. So kann bei einer Spannungsüberwachung der Anlage ein 110% Grenzwert eingehalten werden und bei Überschreitung von beispielsweise einer Spannung von 253 Volt eine Freischaltung der Wechselrichter erfolgen, so dass keine Energie in das Netz eingespeist wird. Ein Grenzwert kann auch ein Strom oder eine Spannung sein. Über die Kommunikationsverbindung kann somit in das System eingegriffen werden.

Besonders günstig ist es, wenn über die zentrale Steuer- und Überwachungseinheit eine Netzspannung, eine Netzstrommessung und/oder eine Frequenzbandmessung erfolgt.
Grundsätzlich ist die zentrale Steuer- und Überwachungseinheit für eine Inselnetzerkennung z. B. durch dreiphasige Spannungsmessung geeignet. Durch die Inselnetzerkennung kann die Anlage bei Netzausfall ohne ein zentrales Schütz abgeschaltet werden.
Zweckmäßigerweise verfügt die Anlage daher über eine Inselnetzerkennungsfunktion, die von der Steuer- und Überwachungseinheit gesteuert wird.

Bei einer weiteren vorteilhaften Ausführung der Erfindung umfasst die Anlage eine Fault-Ride-Through-Überwachungsfunktion. Hierbei wird festgelegt, wie lange der Wechselrichter vom Netz getrennt werden darf.

Um zeitnah eine Inselnetzerkennung oder eine Fault-Ride-Through-Funktion einsetzen zu können, sind zusätzlich zur zentralen Steuer- und Überwachungseinheit weitere dezentrale Steuer- und Überwachungseinheiten vorhanden. Insofern ist jeder Wechselrichter zusätzlich mit einer eigenen Steuer- und Überwachungseinheit ausgestattet.

Eine besonders bevorzugte Ausführungsform der Photovoltaikanlage besteht darin, dass eine modulare Anordnung der Wechselrichter möglich ist, wobei für jede Phase eine Gruppe von mehreren Photovoltaikwechselrichtern parallel anschließbar ist.

Eine weitere durch die Erfindung realisierbare Maßnahme besteht darin, dass die Steuer- und Überwachungseinheit eine Kommunikationsverbindung mit einem Energieversorgungsunternehmen umfasst. Über die Kommunikationsverbindung mit dem Energieversorgungsunternehmen können Daten, wie beispielsweise Energieerträge der Photovoltaikanlage, dem Energieversorgungsunternehmen übermittelt werden, und zwar ohne dass eine vor-Ort-Ablesung erforderlich ist. Diese Kommunikationsverbindung des Energieversorgungsunternehmens kann auch dazu genutzt werden, um eine zentrale Fernabschaltung der Photovoltaikanlage zu schaffen. Bei einem Überangebot an Energie können einzelne dezentrale Einspeiser abgeschaltet werden.

Die Kommunikationsverbindung kann nicht nur eine leistungsgebundene Verbindung, z. B. RS 485-Busverbindung, sondern auch eine drahtlose Verbindung, wie eine Funkverbindung durch Bluetooth, sein.

Außerdem können in derselben Anlage ein- und dreiphasige Wechselrichter miteinander kombiniert werden, beispielsweise indem ein vorhandener dreiphasiger Wechselrichter durch drei einphasige Wechselrichter einer neuen Wechselrichtergeneration ergänzt werden.

Der Einsatz der Erfindung ist bei Leistungen größer 30 kVA vorteilhaft, weil bei dieser Größenordnung jeder Wechselrichter ohnehin mit einer selbsttätigen Freischaltstelle und somit mit einer Trenneinrichtung versehen werden muss. Die Freischaltstellen ersetzen somit den zentralen Schalter.

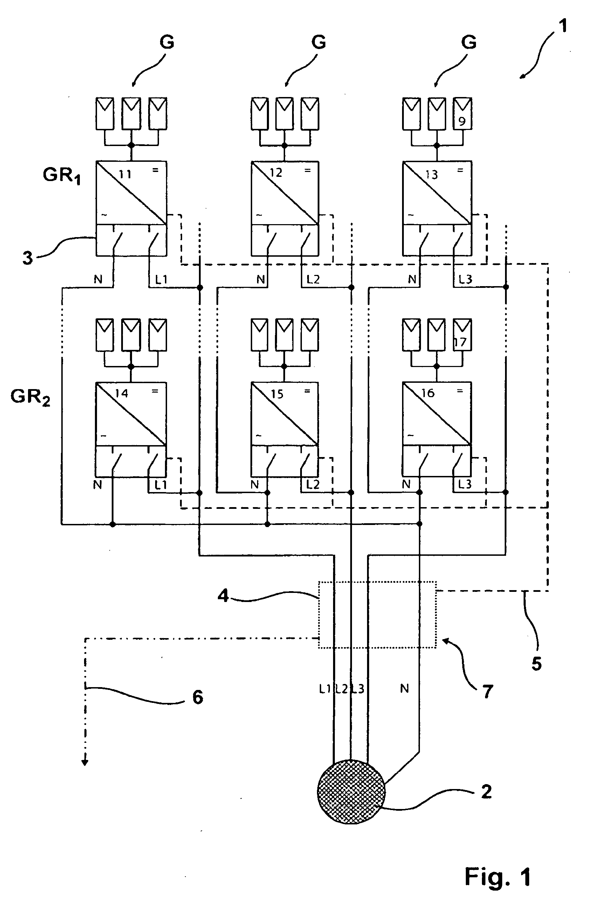

Ein Ausführungsbeispiel wird anhand der Zeichnung näher erläutert, wobei weitere vorteilhafte Weiterbildungen der Erfindung und Vorteile derselben beschrieben sind.

Die Figur zeigt ein Ausführungsbeispiel einer erfindungsgemäßen Photovoltaikanlage.

Die Photovoltaikanlage 1 dient zur dreiphasigen Energieeinspeisung in ein elektrisches Energieversorgungsnetz 2.

Gezeigt ist eine Anlage mit einphasigen Wechselrichtern 11 bis 16; möglich ist der Einsatz allerdings auch von dreiphasigen Wechselrichtern. Der Phase L1 sind die Wechselrichter 11 und 14, der Phase L2 sind die Wechselrichter 12 und 15, und der Phase L3 sind die Wechselrichter 13 und 16 zugeordnet. Zwei Wechselrichter pro Phase, beispielsweise 11 und 14, sind parallel geschaltet.

Jeder Wechselrichter 11 - 16 ist ausgangsseitig mit dem Energieversorgungsnetz 2 verbindbar, und zwar jeweils durch eine interne Freischaltstelle bzw. eine Trenneinrichtung 3, die direkt dem Wechselrichter 11 bis 16 nachgeschaltet ist.

Weiterhin umfasst die Anlage 1 mehrere Photovoltaikgeneratoren G, die an der Eingangsseite der Photovoltaikwechselrichter 11 bis 16 angeschlossen sind.

Zwischen den Photovoltaikwechselrichtern 11 bis 16 bzw. den Trenneinrichtungen 3 und dem Energieversorgungsnetz 2 ist eine zentrale Steuer- und Überwachungseinheit 4 angeschlossen. Die Steuer- und Überwachungseinheit 4 weist eine sogenannte Netzüberwachungseinrichtung (ENS) am Einspeisepunkt des Netzes 2 auf, die ein oder mehrere Netzparameter misst. Solche Parameter können ein Strom, eine Spannung und/oder Frequenzen bzw. ein Frequenzband sein. Es besteht eine interne Kommunikationsverbindung 5 zwischen den einzelnen Photovoltaikwechselrichtern 11 bis 16 und der angeschlossenen zentralen Steuer- und Überwachungseinheit 4. Alternativ könnte diese Verbindung zu den Trenneinrichtungen 3 führen. Die einzelnen Photovoltaikwechselrichter 11 bis 16 sind durch ein Steuerbefehlsignal der Kommunikationsverbindung 5 durch ihre Trenneinrichtungen 3 vom Energieversorgungsnetz trennbar. Beispielsweise sind die Trenneinrichtungen 3 als Schütze zur galvanischen Trennung ausgeführt.

Durch die zentrale Steuer- und Überwachungseinheit 4 soll in erster Linie erreicht werden, dass bei Über- oder Unterschreitung der Spannung einer Phase über vorgegebene Grenzwerte alle Wechselrichter vom Netz 2 getrennt werden. Hierzu kann ein in der zentralen Steuer- und Überwachungseinheit 4 integriertes Spannungsüberwachungsmodul verwendet werden.

Günstig ist, wenn eine Inselnetzerkennungs-Funktion und/oder eine Fault-Ride-Through-Überwachungsfunktion vorhanden ist. Wichtige Überwachungsfunktionen werden dezentral im Wechselrichter 11 zeitnah realisiert. Deshalb weist jeder einzelne Wechselrichter weiterhin eine eigene Steuer- und Überwachungsfunktion auf.

Um die Qualität der Einspeisung zu verbessern, umfasst die zentrale Steuer- und Überwachungseinheit 4 eine Schieflasterkennungsfunktion und/oder eine Schieflastregelungsfunktion. Die Regelung erfolgt so, dass ein Leistungsunterschied zwischen den einzelnen Phasen nicht mehr als 4,6 kVA und/oder ein 10 Minuten-Mittelwert weniger als 5 kW beträgt. Bei Schieflast kann auch eine Abschaltung durch die Trenneinrichtungen 3 erfolgen.

Wie das Beispiel zeigt, werden zwei Gruppen von Wechselrichtern GR1, GR2 eingesetzt. Die Anordnung der Wechselrichter 11 bis 16 erfolgt modular, wobei für jede Phase L1, L2, L3 eine Gruppe GR1 oder GR2 von mehreren Photovoltaikwechselrichtern 11 - 13 oder 14 - 16 in Parallelschaltung vorgesehen ist, wobei N den Neutralleiter darstellt.

Wie die Figur veranschaulicht, ist die Steuer- und Überwachungseinheit mit einer externen Kommunikationsverbindung 6 versehen, die mit einem Energieversorgungsunternehmen verbunden ist. Über diese Kommunikationsverbindung 6 des Energieversorgungsunternehmens können Daten der Photovoltaikanlage, wie Energieerträge, dem Energieversorgungsunternehmen übermittelt werden. Diese Verbindung 6 kann auch zur zentralen Fernabschaltung der Photovoltaikanlage 1 genutzt werden, damit z. B. Netzarbeiten möglich sind.

Die externe Kommunikationsverbindung 6 kann eine leistungsgebundene Verbindung, z. B. eine Busverbindung, wie RS 485-Verbindung sein oder auch eine drahtlose Verbindung, wie eine Funkverbindung, z. B. Bluetooth, sein.

Am Einspeisepunkt 7 werden also die Netzspannungen oder Ströme zur Beurteilung der Schieflast oder Spannungs- und Frequenzbänder von der Zentraleinheit gemessen. Durch die interne Kommunikationsverbindung kann in das System eingegriffen werden. Beispielsweise führt die Detektion der Schieflast zwischen den Phasen L1 - L3 zum Ausregeln der Schieflast. Die Überschreitung von vorgegebenen Grenzwerten führt zum Abschalten der Anlage, wobei die Trenneinrichtungen 3 jedes einzelnen Wechselrichters 11 - 16 geöffnet werden.

Jeder Wechselrichter weist zusätzlich eine eigene Steuer- und Überwachungsfunktion auf, so dass eine Kombination aus einer dezentralen und einer zentralen Überwachungseinheit besteht. Die Funktion der dezentralen und zentralen Einheit ist jedoch unterschiedlich. Die dezentralen Überwachungseinheiten können über dieselbe interne Kommunikationsverbindung 5 miteinander kommunizieren.

### Bezugszeichenliste

- 1: Photovoltaikanlage
- 2: Energieversorgungsnetz
- 3: Trenneinrichtung
- 4: Überwachungseinheit
- 5: Interne Kommunikationsverbindung
- 6: Externe Kommunikationsverbindung
- 7: Einspeisepunkt

- 11-16: Photovoltaikwechselrichter
- L1-L3: Phasen
- GR1-GR2: Gruppen
- G: Photovoltaikgeneratoren
- N: Neutralleiter

## Patentansprüche

1. Photovoltaikanlage (1) zur dreiphasigen Einspeisung in ein elektrisches Energieversorgungsnetz (2) mit
- mehreren ein- oder dreiphasigen Photovoltaikwechselrichtern (11-16), die ausgangsseitig mit dem Energieversorgungsnetz (2) verbindbar sind, wobei jeder Photovoltaikwechselrichter (11-16) ausgangsseitig jeweils eine Trenneinrichtung (3) aufweist,
- mehreren Photovoltaikgeneratoren (G), die an der Eingangsseite der Photovoltaikwechselrichter (11-16) angeschlossen sind,
- einer zwischen den Photovoltaikwechselrichtern (11-16) und dem Energieversorgungsnetz (2) angeschlossenen zentralen Steuer- und Überwachungseinheit (4),
- wobei die zentrale Steuer- und Überwachungseinheit (4) eine Netzüberwachungseinrichtung am Einspeisepunkt (7) des Netzes aufweist, die ein oder mehrere Netzparameter misst, und wobei die zentrale Steuer- und Überwachungseinheit (4) eine Schieflasterkennungsfunktion und/oder eine Schieflastregelungsfunktion umfasst,
**dadurch gekennzeichnet, dass**
- eine Kommunikationsverbindung (5) zwischen den einzelnen Photovoltaikwechselrichtern (11-16) oder den einzelnen Trenneinrichtungen (3) und der angeschlossenen zentralen Steuer- und Überwachungseinheit (4) vorgesehen ist,
- und die zentrale Steuer- und Überwachungseinheit (4) derart ausgeführt ist, dass bei Überschreitung oder Unterschreitung mindestens eines vorgegebenen Grenzwertes die einzelnen Photovoltaikwechselrichter (11-16) durch ein Steuerbefehlsignal der Kommunikationsverbindung (5) durch ihre Trenneinrichtungen (3) vom Energieversorgungsnetz (2) trennbar sind und dass
- jeder Wechselrichter (11 - 16) eine eigene zusätzliche Steuer- und Überwachungsfunktion umfasst, so dass zusätzlich eine dezentrale Überwachung erfolgt.

2. Photovoltaikanlage nach Anspruch 1, **dadurch gekennzeichnet, dass** durch die Steuer- und Überwachungseinheit (4) eine Netzspannung und/oder eine Netzstrommessung und/oder eine Frequenzbandmessung erfolgt.

3. Photovoltaikanlage nach Anspruch 2, **dadurch gekennzeichnet, dass** die zusätzliche Steuer- und Überwachungsfunktion der Inselnetzerkennungsfunktion dient.

4. Photovoltaikanlage nach Anspruch 2 oder 3, **dadurch gekennzeichnet, dass** die zusätzliche Steuer- und Überwachungsfunktion eine Fault-Ride-Through-Überwachungsfunktion ist.

5. Photovoltaikanlage nach einem der vorhergehenden Ansprüche, **dadurch gekennzeichnet, dass** die Regelung so erfolgt, dass ein Leistungsunterschied zwischen den einzelnen Phasen (L1 - L3) nicht mehr als 4,6 kVA und/oder ein 10-Minuten-Mittelwert weniger als 5 kW beträgt.

6. Photovoltaikanlage nach einem der Ansprüche 1 bis 4, **dadurch gekennzeichnet, dass** die zentrale Steuer- und Überwachungseinheit eine Schieflasterkennungsfunktion umfasst und bei einer Schieflast eine Abschaltung durch die Trenneinrichtungen (3) erfolgt.

7. Photovoltaikanlage nach einem der vorhergehenden Ansprüche, **gekennzeichnet durch** eine modulare Anordnung der Wechselrichter (11-16), so dass für jede Phase (L1 -L3) eine Gruppe (GR1, GR2) von mehreren Photovoltaikwechselrichtern (11-16) parallel anschließbar ist.

8. Photovoltaikanlage nach einem der vorhergehenden Ansprüche, **dadurch gekennzeichnet, dass** die Steuer- und Überwachungseinheit (4) eine externe Kommunikationsverbindung (6) mit einem Energieversorgungsunternehmen umfasst.

9. Photovoltaikanlage nach Anspruch 8, **dadurch gekennzeichnet, dass** durch die externe Kommunikationsverbindung (6) mit dem Energieversorgungsunternehmen Daten der Photovoltaikanlage (1) dem Energieversorgungsunternehmen übermittelt werden.

10. Photovoltaikanlage nach Anspruch 8 oder 9, **dadurch gekennzeichnet, dass** durch die externe Kommunikationsverbindung (6) mit dem Energieversorgungsunternehmen eine zentrale Fernabschaltung der Photovoltaikanlage (1) erfolgt.

11. Photovoltaikanlage nach einem der vorhergehenden Ansprüche, **dadurch gekennzeichnet, dass** die Kommunikationsverbindung (5) eine leitungsgebundene Verbindung, insbesondere eine Busverbindung, vorzugsweise eine RS 485-Verbindung, ist, oder dass die Kommunikationsverbindung (5) eine drahtlose Verbindung, insbesondere eine Funkverbindung, vorzugsweise eine Bluetooth Verbindung ist.

12. Photovoltaikanlage nach einem der vorhergehenden Ansprüche, **gekennzeichnet durch** Photovoltaikwechselrichter (11-16) unterschiedlicher Phasen-Typen oder den Einsatz von nur einphasigen Photovoltaikwechselrichtern (11-16).

13. Photovoltaikanlage nach einem der vorhergehenden Ansprüche, **gekennzeichnet durch** eine Leistung größer als 30 kVA.

## Claims

1. A photovoltaic system (1) configured to feed three-phase current into a power grid (2), comprising:
a plurality of single-phase or three-phase photovoltaic inverters (11-16) configured to be connected to the power grid (2) on an output side,
wherein each of the photovoltaic inverters (11-16) comprise a disconnector (3) on the output side thereof,
a plurality of photovoltaic generators (G) connected to the input side of the photovoltaic inverters (11-16),
a central control and monitoring unit (4) connected between the photovoltaic inverters (11-16) and the power grid (2),
wherein the central control and monitoring unit (4) comprises a grid monitoring device at a grid feed-in point (7), wherein the grid monitoring device is configured to measure one or more grid parameters,
and wherein the central control and monitoring unit (4) comprises a load unbalance detection function and/or a load unbalance control function,
**characterized in that**
a communication link (5) is provided between the individual photovoltaic inverters (11-16) or the individual disconnectors (3) and the connected central control and monitoring unit (4),
and that the central control and monitoring unit (4) is configured in such a manner, that in case of a exceedance or a undershooting of at least one predetermined limit the photovoltaic inverters (11-16) are separable from the power grid (2) via their disconnectors (3) by means of a control signal of the communication link (5)
and that each inverter (11-16) comprises an additional control and monitoring function to provide an additional decentralized monitoring.

2. The photovoltaic system of claim 1, **characterized in that** the control and monitoring unit (4) is configured to measures a grid voltage and/or a grid current and/or a frequency band.

3. The photovoltaic system of claim 2, **characterized in that** the additional control and monitoring function is configured to detect an island grid.

4. The photovoltaic system of claim 2 or 3, **characterized in that** the additional control and monitoring function comprises a fault ride-through monitoring function.

5. The photovoltaic system of one of the preceding claims, **characterized in that** the load unbalance control function is carried out in such a manner that a power difference between individual phases (L1-L3) is not greater than 4.6 kVA and/or a 10-minute average value is less than 5 kW.

6. The photovoltaic system of one of the claims 1 to 4, **characterized in that** the central control and monitoring unit (4) comprises a load unbalance control function and that in case of a load unbalance condition a shutdown by means of the disconnectors (3) is carried out.

7. The photovoltaic system of one of the preceding claims, **characterized by** a modular arrangement of the inverters (11-16) with the result that a group (GR1, GR2) of a plurality of photovoltaic inverters (11-16) can be connected in a parallel manner for each phase (L1-L3).

8. The photovoltaic system of one of the preceding claims, **characterized in that** control and monitoring unit (4) comprises an external communication link (6) to a power supply company.

9. The photovoltaic system of claim 8, **characterized in that** data relating to the photovoltaic system (1) are transmitted to the power supply company by means of the external communication link (6).

10. The photovoltaic system of claim 8 or 9, **characterized in that** the photovoltaic system (1) is centrally remotely disconnected by means of the external communication link (6) to the power supply company.

11. The photovoltaic system of one of the preceding claims, **characterized in that** the communication link (5) comprises a wired link, in particular a bus connection, preferably an RS 485 connection, or **in that** the communication link (5) is a wireless link, in particular a radio link, preferably a Bluetooth link.

12. The photovoltaic system of one of the preceding claims, **characterized in that** photovoltaic inverters (11-16) of different phase types or solely single-phase photovoltaic inverters (11-16) are used.

13. The photovoltaic system of one of the preceding claims, **characterized by** a power greater than 30kVA.

## Revendications

1. Installation photovoltaïque (1) destinée à l'injection triphasée dans un réseau de distribution d'énergie électrique (2) comprenant
- plusieurs onduleurs photovoltaïques (11-16) mono-ou triphasés dont la sortie peut être raccordée au réseau de distribution d'énergie (2), chaque onduleur photovoltaïque (11-16) possédant en sortie à chaque fois un dispositif de sectionnement (3),
- plusieurs générateurs photovoltaïques (G) qui sont raccordés au côté entrée des onduleurs photovoltaïques (11-16),
- une unité centrale de commande et de surveillance (4) raccordée entre les onduleurs photovoltaïques (11-16) et le réseau de distribution d'énergie (2),
- l'unité centrale de commande et de surveillance (4) possédant un dispositif de surveillance du réseau au point d'injection (7) du réseau, lequel mesure un ou plusieurs paramètres du réseau, et l'unité centrale de commande et de surveillance (4) comprenant une fonction de détection de dissymétrie et/ou une fonction de régulation de dissymétrie,
**caractérisée en ce que**
- une liaison de communication (5) est réalisée entre les onduleurs photovoltaïques (11-16) individuels ou les dispositifs de sectionnement (3) individuels et l'unité centrale de commande et de surveillance (4) raccordée,
- et l'unité centrale de commande et de surveillance (4) est réalisée de telle sorte qu'en cas de franchissement vers le haut ou vers le bas d'au moins une valeur limite prédéfinie, les onduleurs photovoltaïques (11-16) individuels peuvent être déconnectés du réseau de distribution d'énergie (2) par leurs dispositifs de sectionnement (3) par le biais d'un signal d'instruction de commande de la liaison de communication (5), et **en ce que**
- chaque onduleur (11-16) comprend une fonction de commande et de surveillance supplémentaire propre, de sorte qu'une surveillance décentralisée est en plus réalisée.

2. Installation photovoltaïque selon la revendication 1, **caractérisée en ce qu'**une mesure de la tension du réseau et/ou une mesure du courant du réseau et/ou une mesure de la bande de fréquences sont effectuées avec l'unité de commande et de surveillance (4).

3. Installation photovoltaïque selon la revendication 2, **caractérisée en ce que** la fonction de commande et de surveillance supplémentaire sert à la fonction de reconnaissance de réseau en îlot.

4. Installation photovoltaïque selon la revendication 2 ou 3, **caractérisée en ce que** la fonction de commande et de surveillance supplémentaire est une fonction de surveillance de l'alimentation sans panne (FRT).

5. Installation photovoltaïque selon l'une des revendications précédentes, **caractérisée en ce que** la régulation s'effectue de telle sorte qu'une différence de puissance entre les phases individuelles (L1-L3) n'est pas supérieure à 4,6 kVA et/ou possède une valeur moyenne sur 10 minutes inférieure à 5 kW.

6. Installation photovoltaïque selon l'une des revendications 1 à 4, **caractérisée en ce que** l'unité centrale de commande et de surveillance comprend une fonction de détection de dissymétrie et une mise hors circuit par le biais des dispositifs de sectionnement (3) a lieu en présence d'une dissymétrie.

7. Installation photovoltaïque selon l'une des revendications précédentes, **caractérisée en ce qu'**un arrangement modulaire des onduleurs (11-16)est présent, de sorte que pour chaque phase (L1-L3), un groupe (GR1, GR2) de plusieurs onduleurs photovoltaïques (11-16) peut être branché en parallèle.

8. Installation photovoltaïque selon l'une des revendications précédentes, **caractérisée en ce que** l'unité de commande et de surveillance (4) comprend une liaison de communication externe (6) avec une entreprise de distribution d'énergie.

9. Installation photovoltaïque selon la revendication 8, **caractérisée en ce que** des données de l'installation photovoltaïque (1) sont communiquées à l'entreprise de distribution d'énergie par le biais de la liaison de communication externe (6) avec l'entreprise de distribution d'énergie.

10. Installation photovoltaïque selon la revendication 8 ou 9, **caractérisée en ce qu'**une mise hors circuit à distance centralisée de l'installation photovoltaïque (1) est effectuée par le biais de la liaison de communication externe (6) avec l'entreprise de distribution d'énergie.

11. Installation photovoltaïque selon l'une des revendications précédentes, **caractérisée en ce que** la liaison de communication (5) est une liaison filaire, notamment une liaison par bus, de préférence une liaison RS 485, ou **en ce que** la liaison de communication (5) est une liaison sans fil, notamment une liaison radioélectrique, de préférence une liaison Bluetooth.

12. Installation photovoltaïque selon l'une des revendications précédentes, **caractérisée par** des onduleurs photovoltaïques (11-16) de différents types de phase ou l'utilisation de seulement des onduleurs photovoltaïques (11-16) monophasés.

13. Installation photovoltaïque selon l'une des revendications précédentes, **caractérisée par** une puissance supérieure à 30 kVA.
